# EUROPEAN PATENT APPLICATION

(11) **EP 2 645 469 A1**
(43) Date of publication of application: **02.10.2013**
(21) Application number: 11842817.6
(22) Date of filing: 12.10.2011
(51) Int. Cl.: H01M 14/00, H01L 31/04

(54) **DYE ADSORPTION DEVICE, DYE ADSORPTION METHOD, AND SUBSTRATE TREATMENT APPARATUS**

(30) Priority: 25.11.2010 JP 2010262136; 27.05.2011 JP 2011119604
(71) Applicant: Tokyo Electron Limited, Tokyo 107-6325 (JP)
(72) Inventor: WADA, Norio, Kikuchi-gun Kumamoto 869-1232 (JP); TERADA, Takashi, Kikuchi-gun Kumamoto 869-1232 (JP); FUKUDA, Yoshiteru, Kikuchi-gun Kumamoto 869-1232 (JP); FURUTANI, Goro, Koshi-shi Kumamoto 861-1116 (JP)
(74) Representative: HOFFMANN EITLE
(86) International application number: PCT/JP2011/005707
(87) International publication number: WO 2012/070181

(57) **Abstract**

[Problem] To significantly reduce processing time of a step of adsorbing dye in a porous semiconductor layer on a substrate surface.

[Solution] A flow of a dye solution is formed in a gap between solution guide surface (92L, 92R) of a nozzle (20) and a substrate (G) during the treatment, and a porous semiconductor layer of a treated surface of the substrate is subject to dye adsorption treatment in this flow of the dye solution. Furthermore, impact pressure from slit-like discharge openings (88L, 88R) and pressure of turbulent flow in groove-like uneven sections (92L, 92R) act in the vertical direction in addition to the flow of the dye solution. Thus, aggregation and association of the dye are hardly caused on a surface part of the porous semiconductor layer of the treated surface of the substrate, the dye efficiently penetrates deeply into the porous semiconductor layer, and the dye adsorption into the porous semiconductor layer proceeds at high speed.

## Description

### Technical Field

The present invention relates to a dye adsorption device, a dye adsorption method and a substrate treatment apparatus for adsorbing a dye into a porous semiconductor layer formed on a surface of a substrate.

### Background

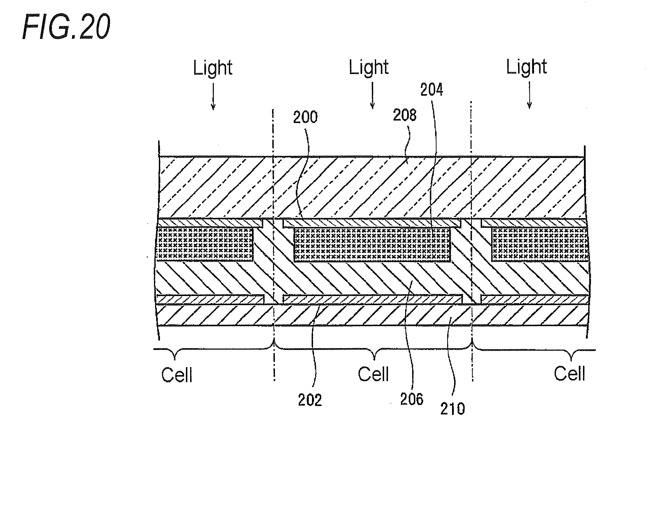

Recently, a dye sensitization solar cell has been considered as promising as a future inexpensive solar cell. As illustrated in FIG. 20, a dye sensitization solar cell includes, as a basic structure, a porous semiconductor layer 204 impregnated with a sensitizing dye and an electrolyte layer 206 between a transparent electrode (negative electrode) 200 and a counter electrode (positive electrode) 202.

Here, the semiconductor layer 204 is divided into a plurality of cells together with the transparent electrode 200, the electrolyte layer 206, and the counter electrode 202, and formed on a transparent substrate 208 in which the transparent electrode 200 is interposed between the semiconductor layer 204 and the transparent substrate 208. The rear surface side of the counter electrode 202 is covered with a counter substrate 210. The transparent electrode 200 of each cell is electrically connected with a neighboring counter electrode 202 and the plurality of cells are electrically connected with each other either in series or in parallel in an entire module.

In the dye sensitization solar cell configured as described above, when visible light is illuminated from the rear surface side of the transparent substrate 208, the dye impregnated in the semiconductor layer 204 is excited to emit electrons. The emitted electrons are guided to the transparent electrode 200 through the semiconductor layer 204 and then emitted to the outside. The emitted electrons return to the counter electrode 202 via an external circuit (not illustrated) and are received in the dye in the semiconductor layer 204 again through the ions in the electrolyte layer 206. In this manner, optical energy is immediately converted into electric power which is in turn output.

In a process of fabricating such a dye sensitization solar cell, a method of immersing the porous semiconductor layer 204 formed on the transparent substrate 208 in a dye solution so as to adsorb a sensitizing dye into the porous semiconductor layer 204 has been employed in the related art.

### Prior Art Document

### Patent Document

Patent Document 1: Japanese Patent Laid-Open Publication No. 2006-244954

### Disclosure of the Invention

### Problem to Be Solved by the Invention

The above-described immersing method requires at least scores of hours in the dye adsorption processing which may vary depending on the types of the dye and thus, becomes the cause of rate-determining of tact of the entire steps in a process of fabricating a dye sensitization solar cell and decreasing manufacturing efficiency. In connection with this problem, it may be considered to operate a plurality of immersion type dye adsorption devices in parallel which requires at least scores of dye adsorption devices to be prepared, which is not practical.

The present invention has been made to solve the problems of the related art as described above and provides a dye adsorption device and a dye adsorption method capable of significantly reducing the amount of processing time in a step of adsorbing dye into a porous semiconductor layer formed on a treated surface of a substrate.

Also, the present invention provides a substrate treatment apparatus capable of significantly reducing the amount of processing time in a step of adsorbing dye into a porous semiconductor layer formed on a surface to be treated ("treated surface") of a substrate, and efficiently preventing or suppressing aggregation and precipitation of the dye.

### Means to Solve the Problems

A dye absorption apparatus according to the present invention is an apparatus of adsorbing a dye into a porous semiconductor layer formed on a treated surface of a substrate. The apparatus includes: a holding unit configured to hold the substrate such that the treated surface of the substrate faces upward; a nozzle having an ejection port and disposed above the holding unit so that the ejection port faces downward; and a dye solution supply unit configured to pump a dye solution formed by solving the dye in a predetermined solvent to the nozzle. The dye solution is ejected from the ejection port of the nozzle to the treated surface of the substrate held on the holding unit through a first gap so that a flow of the dye solution is formed on the treated surface of the substrate and the dye contained in the dye solution is adsorbed into the semiconductor layer.

A dye adsorption method according to the present invention is a method of adsorbing a dye into a porous semiconductor layer formed on a treated surface of a substrate. The method includes: disposing the substrate at a predetermined position such that the treated surface of the substrate faces upward; positioning the nozzle to be opposed to the substrate; pumping a dye solution formed by solving the dye in a predetermined solvent to the nozzle and ejecting the dye solution from the ejection port of the nozzle to the treated surface of the substrate held on the holding unit through a first gap so that a flow of the dye solution is formed on the treated surface of the substrate and the dye contained in the dye solution is adsorbed into the semiconductor layer.

In the dye adsorption device or method of the present invention, a flow of the dye solution is formed in the gap between the guide surface of the nozzle and the substrate during the processing, and the porous semiconductor layer of the treated surface of the substrate is subject to a dye adsorption processing in the flow of the dye solution. Also, in addition to the flow of the dye solution, impact pressure from the ejection port acts in the vertical direction. Thus, aggregation or cohesion of the dye is hardly caused on a surface layer portion of the porous semiconductor layer, the dye may efficiently penetrate deeply into the porous semiconductor layer, and the dye adsorption into the porous semiconductor layer may proceed at high speed.

According to an aspect of the present invention, an uneven section is formed on the solution guide surface of the nozzle so that whirlpool or turbulent flow is formed in the dye solution on the uneven section. Thus, it becomes easier for the dye solution to penetrate deeply into the treated surface (porous semiconductor layer) of the substrate.

Further, according to an aspect of the present invention, there is provided a suction section which is positioned at a trailing end of the flow of the dye solution on the substrate to suck in the dye solution. Preferably, the suction section includes a suction port formed on the bottom surface of the nozzle and a vacuum passage formed within the nozzle. By the suction action of the suction section, the flow of the dye solution may be smoothly formed on the substrate, and the dye adsorption may be further facilitated.

A substrate treatment apparatus according to the present invention includes: a holding unit configured to hold a substrate formed with a porous semiconductor treated surface such that the treated surface faces upward; a dye adsorption unit configured to adsorb dye to the semiconductor layer of the substrate held on the holding unit; and a rinse unit configured to wash out extra dye from a surface of the semiconductor layer of the substrate. The dye adsorption unit includes: a first nozzle having an ejection port and disposed above the holding unit such that the ejection port faces downward, and a dye solution supply unit configured to pump dye solution in which the dye is solved in a predetermined solvent to the first nozzle. The dye solution is ejected from the ejection port of the nozzle to the treated surface of the substrate held on the holding unit through a first gap to form a flow of the dye solution on the treated surface of the substrate and to adsorb the dye contained in the dye solution into the semiconductor layer.

In the substrate treatment apparatus of the present invention, a flow of dye solution is formed in a gap between the guide surface of the nozzle and the substrate during the dye adsorption processing, the porous semiconductor layer of the treated surface of the substrate is subject to dye adsorption processing in the flow of the dye solution. Also, in addition to the flow of the dye solution, impact pressure from the ejection port acts in the vertical direction. Thus, aggregation or cohesion of dye is hardly caused on a surface layer portion of the porous semiconductor layer, the dye may efficiently penetrate deeply into the porous semiconductor layer, and the dye adsorption into the porous semiconductor layer may proceed at high speed. Further, a rinse processing is performed following the dye adsorption processing to remove extra dye from the surface of the semiconductor layer on the substrate. Thus, the cohesion and precipitation of dye on a surface layer portion of the porous semiconductor layer may be efficiently prevented or suppressed.

### Effect of the Invention

According to the dye adsorption device or dye adsorption method of the present invention, a processing time in a step of adsorbing dye into a porous semiconductor layer on a treated surface of a substrate may be significantly reduced by the configurations and actions as described above.

In addition, according to the substrate treatment apparatus of the present invention, processing time in a step of adsorbing dye into a porous semiconductor layer on a treated surface of a substrate may be significantly reduced and the cohesion and precipitation of dye on a surface layer portion of the porous semiconductor layer may be efficiently prevented or suppressed by the configurations and actions as described above.

### Brief Description of the Drawings

FIG. 1 is a cross-sectional view illustrating a configuration of a dye adsorption device according to an exemplary embodiment of the present invention.
FIG. 2 is a plan view illustrating a principal portion of the dye adsorption device.
FIG. 3A is a perspective view illustrating a configuration of a principal portion of a nozzle in the dye adsorption device.
FIG. 3B is a longitudinal sectional view illustrating the principal portion of the nozzle.
FIG. 4 is a cross-sectional view for schematically describing actions in the dye adsorption device in the vicinity of the surface of the substrate.
FIG. 5 is a view illustrating a size requirement in groove-like uneven sections.
FIG. 6 is a perspective view illustrating a state in which the nozzle stands by on the standby bus.
FIG. 7 is a longitudinal sectional view illustrating the state of the nozzle standing by on the standby bus.
FIG. 8 is a cross-sectional view illustrating a configuration of a substrate treatment apparatus according to an exemplary embodiment of the present invention.
FIG. 9A is a perspective view illustrating a modified example of the groove-like uneven sections of the nozzle.
FIG. 9B is a longitudinal sectional view illustrating the configuration of the nozzle of FIG. 9A.
FIG. 10 is a perspective view illustrating a modified example of the ejection passage and the ejection port of the nozzle.
FIG. 11 is a longitudinal sectional view illustrating a modified example of the groove-like uneven sections of the nozzle.
FIG. 12 is a longitudinal sectional view illustrating a modified example of the ejection section and the suction section of the nozzle.
FIG. 13A is a perspective view illustrating an exemplary embodiment in which the groove-like uneven sections are omitted in the nozzle.
FIG. 13B is a longitudinal sectional view illustrating a principal part of the nozzle of FIG. 13A.
FIG. 14A is a perspective view illustrating an exemplary embodiment in which the suction section is omitted in the nozzle.
FIG. 14B is a longitudinal sectional view illustrating a configuration of a principal part of the nozzle of FIG. 14.
FIG. 15A is a perspective view illustrating an exemplary embodiment in which the suction section is omitted in the nozzle of FIG. 15A.
FIG. 15B is a longitudinal sectional view illustrating a configuration of a principal part of the nozzle of FIG. 15A.
FIG. 16A is a time-pressure diagram representing a method of varying the ejecting pressure of the nozzle during the treatment.
FIG. 16B is a time-pressure diagram representing another method of varying the ejecting pressure of the nozzle during the treatment.
FIG. 17 is a plan view illustrating an exemplary embodiment in which the nozzle is formed to have a size to cover the substrate.
FIG. 18 is a plan view illustrating an exemplary embodiment in which the nozzle is formed in a disc shape.
FIG. 19 is a plan view illustrating an exemplary embodiment in which the substrate is rectilinearly moved or reciprocated during the treatment.
FIG. 20 is a longitudinal sectional view illustrating a basic structure of a dye sensitization solar cell.

### Detailed Description to execute the Invention

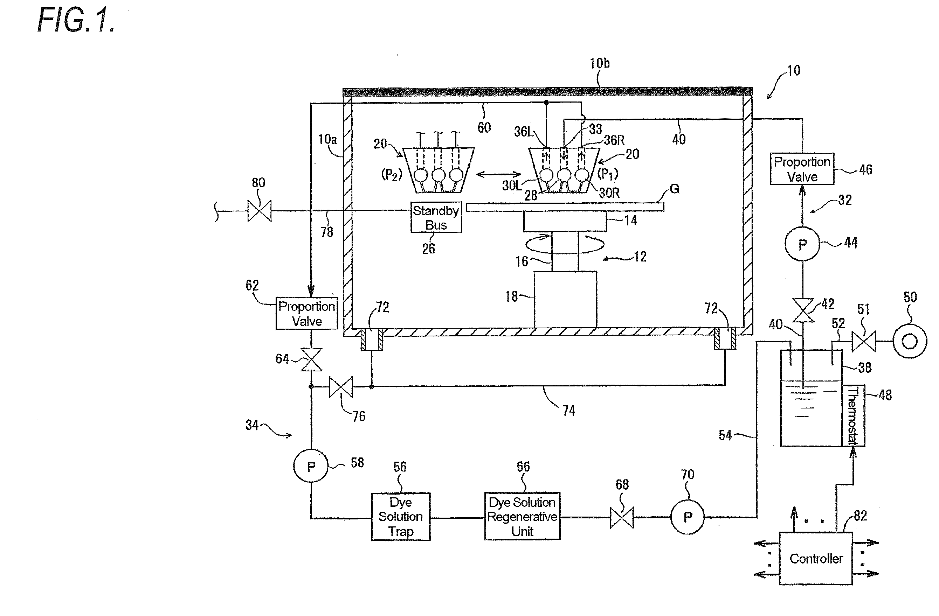

Hereinbelow, exemplary embodiments of the present invention will be described with reference to FIGS. 1 to 19.

### [Exemplary Embodiment 1]

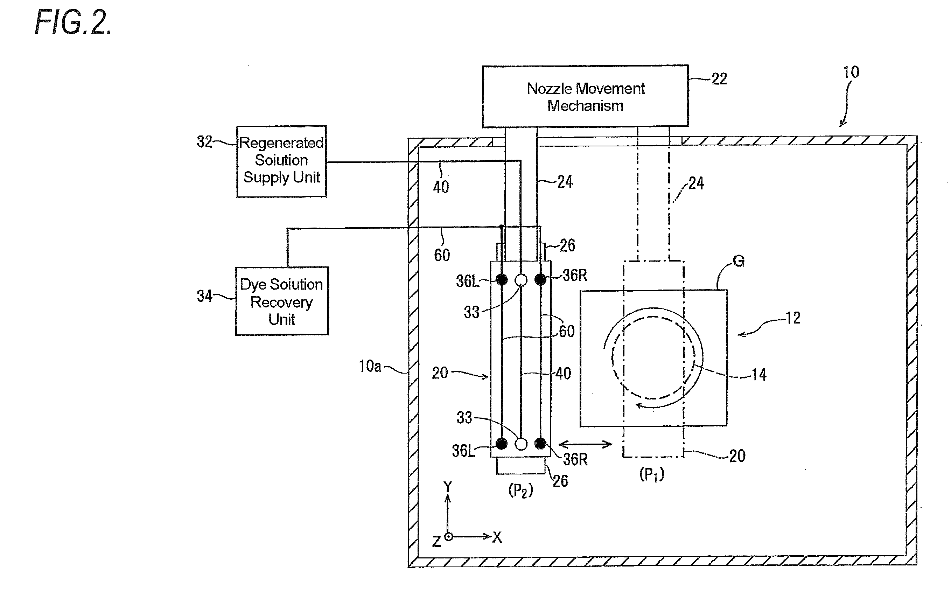

FIGS. 1 and 2 illustrate the entire configuration of the dye adsorption device according to an exemplary embodiment of the present invention. The dye adsorption device may be used, for example, in a step of adsorbing sensitizing dye into a porous semiconductor layer in a single wafer type in a process of fabricating a dye sensitization solar cell. In such a case, a transparent substrate formed with a transparent electrode 200 and a porous semiconductor layer 204 before counterpart members (a counter electrode 202, a counter substrate 210 and an electrolyte layer 206) are combined (FIG. 20) will be a treated substrate G in the dye adsorption device.

Here, the transparent substrate 208 is made up of, for example, a transparent inorganic material such as, for example, quartz or glass, or a transparent plastic material such as, for example, polyester, acryl or polyimide. The transparent electrode 200 is made up of, for example, fluorine doped SnO₂ (FTO) or indium-tin oxide (ITO). In addition, the porous semiconductor layer 204 may be made up of, for example, a metal oxide such as, for example, TiO₂ ZnO or SnO₂. The substrate G has a predetermined shape (e.g., a quadrilateral shape) and a predetermined size and is carried into/carried out from the dye adsorption device by a transport robot (not illustrated).

As illustrated in FIGS. 1 and 2, the dye adsorption device includes a processing chamber 10 capable of being opened to an atmospheric space, and a substrate holding unit 12 is installed at a central part of the processing chamber 10. The substrate holding unit 12 includes a chuck plate 14 of a disc shape configured as a spin chuck to hold the substrate G to be rotatable horizontally and having a diameter smaller than the length of a smaller side of the substrate G, and a driving unit 18 configured to rotationally drive the chuck plate 14 in the circumferential direction through a rotating support shaft 16.

For example, concentric and/or radial grooves are formed on the top surface (substrate placement surface) of the chuck plate 14 and connected to a negative pressure source, for example, a vacuum pump (not illustrated) through a vacuum passage that extends through the interior of the rotating support shaft 16 and the driving unit 18. When the substrate G is placed on the chuck plate 14 in a state where the treated surface formed with the semiconductor layer 204 faces upward, negative pressure from the negative pressure source is imparted to each of the grooves on the top surface of the chuck plate 14, and suction force of negative pressure acts on the rear surface of the substrate G from each of the grooves, thereby fixing and holding the substrate G on the chuck plate 14. The substrate holding unit 12 is provided with a lift pin mechanism (not illustrated) configured to raise or lower the substrate G on the chuck plate 14 at the time of carrying-in/carrying-out of the substrate G.

An opening (not illustrated) configured to be capable of being opened/closed is formed in a side wall 10a of the processing chamber 10. The top cover 10b of the processing chamber 10 is formed with a plurality of vent holes (not illustrated) so as to introduce clean air into the chamber from the outside. Alternatively, the top side may be entirely opened without the top cover 10b, or a fan filter unit (FFU) may be installed on the ceiling of the processing chamber 10.

In the inside of the processing chamber 10, a movable nozzle 20 is installed above the substrate holding unit 12. The nozzle 20 is configured to be supported horizontally and to be movable horizontally between a processing position P₁ set on the chuck plate 14 and a standby position P₂ on a standby bus 26 installed next to the chuck plate 14 by a nozzle movement mechanism 22 installed in the outside of the processing chamber 10 and via an arm 24. The nozzle movement mechanism 22 includes a rectilinear driving mechanism such as, for example, a ball-screw mechanism or a linear motor, and further includes a lift mechanism that varies or adjusts the height position of the nozzle 20 in the vertical direction.

As described below in detail, the nozzle 20 includes an ejection section 28 configured to eject dye solution onto the substrate G and suction sections 30L, 30R configured to suck in the dye solution from the substrate G. One or more inlet ports 33 configured to introduce dye solution sent from a dye solution supply unit 32 into the ejection section 28 and one or more outlet ports 36L, 36R configured to discharge the dye solution sucked in from the suction sections 30L, 30R to the outside of the nozzle 20 so as to send the dye solution to a dye solution recovery unit 34 are provided on the top surface of the nozzle 20.

The dye solution supply unit 32 includes a tank 38 configured to store the dye solution, a dye solution supply line 40 configured by, for example, a pipe configured to connect the tank 38 and the inlet ports 33 of the nozzle, an electromagnetic open/close valve 42, a supply pump 44, and an electromagnetic proportion valve 46. The electromagnetic open/close valve 42, the supply pump 44, and the electromagnetic proportion valve 46 are provided on the way of the dye solution supply line 40. The electromagnetic proportion valve 46 is used in order to variably control or adjust the pressure or flow rate of the dye solution drawn up from the tank 38 and pumped to the nozzle 20 by the supply pump 44.

A thermostat 48 is attached to the tank 38 to adjust the temperature of the dye solution to a predetermined treatment temperature which is suitable for dye adsorption processing. Also, a new solution supply pipe 52 from the dye solution supply source 50 and a regenerated solution supply pipe 54 from a dye solution recover unit 34 to be described are connected to the tank 38 so as to replenish the tank 38 with dye solution.

In addition, the dye solution used in the dye adsorption device is formed by solving sensitizing dye in a solvent with a predetermined concentration. As for the sensitizing dye, for example, a metal complex such as, for example, metal phthalocyanine, or an organic dye such as, for example, a cyanine-based dye or a basic dye may be used. As for the solvent, for example, alcohols, ethers, amides, or a hydrocarbon may be used.

The dye solution recovery unit 34 includes a suction pump 58 configured to suck in and send the dye solution together with air to a dye solution trap 56, a vacuum line 60 configured by, for example, a pipe configured to connect the inlet side of the suction pump 58 and the outlet ports 36L, 36R of the suction pump 58, an electromagnetic proportion valve 62, and an electromagnetic open/close valve 64 in which the electromagnetic proportion valve 62 and the electromagnetic open/close valve 64 are provided on the way of the vacuum line 60. The electromagnetic proportion valve 64 is used in order to variably control or adjust the negative pressure discharging the dye solution from the outlet ports 36L, 36R of the nozzle 20 or the flow rate of the dye solution discharged from the outlet ports 36L, 36R of the nozzle 20.

The dye solution trap 56 collects the recovered dye solution sent from the outlet side of the suction pump 58 together with air in a trap member by, for example, a labyrinth method or a cyclone method, and sends the recovered and collected dye solution to a dye solution regenerative unit 66. The dye solution regenerative unit 66 includes, for example, a filter and a concentration adjustment unit, and produces the regenerated dye solution that has a component and a concentration which are substantially the same as those of new dye solution from the recovered dye solution. An electromagnetic open/close valve 68 and a pump 70 are provided on the way of the regenerated solution supply pipe 54 that interconnects the dye solution regenerative unit 66 and the tank 38 so that the regenerated dye solution may be frequently supplied to the tank 38 from the dye solution regenerative unit 66 through the regenerated solution supply pipe 54. In addition, the electromagnetic open/close valve 51 is also provided on the way of the new solution supply pipe 52 so that the new dye solution may be frequently supplied to the tank 38 from the dye solution supply source 50 through the new solution supply pipe 52. In this manner, the reuse of the dye solution is enabled and thus, the consumption of new dye solution may be reduced.

One or more exhaust/drain ports 72 are formed on the bottom surface of the processing chamber 10 and connected to the inlet side of the suction pump 58 through an exhaust/drain line 74 configured by, for example, a pipe. An electromagnetic open/close valve 76 is provided on the way of the exhaust/drain line 74.

In addition, an exhaust line 78 is also connected to a standby bus 26 to be described later. The exhaust line 78 may be connected to the inlet side of the suction pump 58 but is preferably connected to a separate exhaust pump (not illustrated). An electromagnetic open/close valve 80 is also provided on the way of the exhaust line 78.

A controller 82 includes a microcomputer and an interface as needed, controls each unit in the dye adsorption device, and further controls the sequence of the entire apparatus that executes the dye adsorption processing.

Here, the configuration of the nozzle 20 is described in detail. As illustrated in FIG. 2, the nozzle 20 is an elongated nozzle extending in a horizontal direction (Y direction) orthogonal to a horizontal movement direction (X direction) and preferably has the whole length longer than a diagonal line of the substrate G.

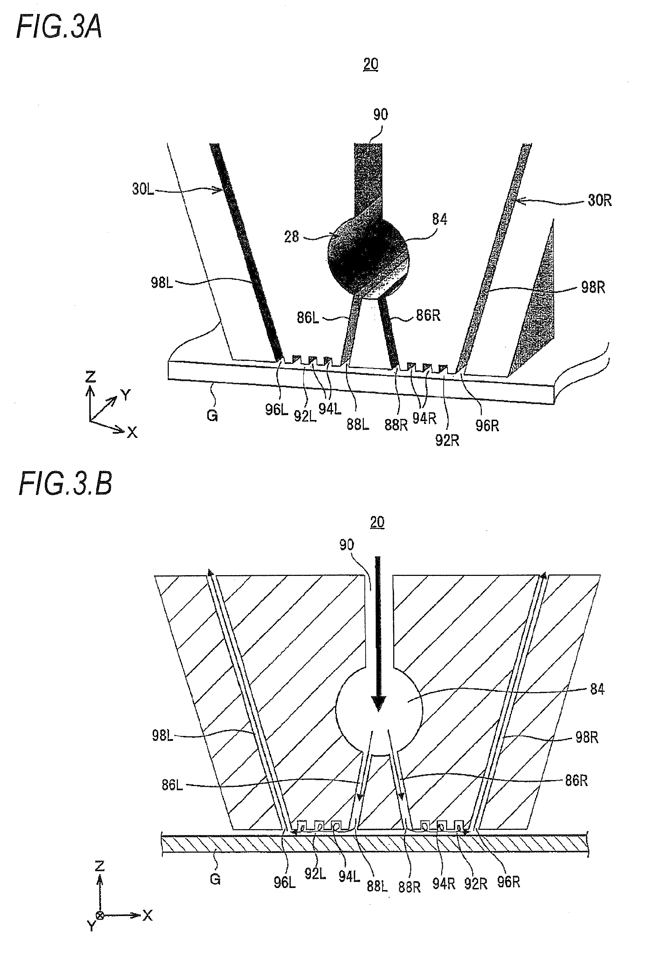

As illustrated in FIG. 3A, the ejection section 28 of the nozzle 20 includes a tunnel-like buffer chamber (manifold) 84 extending in the longitudinal direction of the nozzle (Y direction) at the center of the nozzle 20, a pair of slit-like ejection passages 86L, 86R divided into two from the bottom of the buffer chamber 84 and extending obliquely downward, slit-like ejection ports 88L, 88R formed at the trailing ends of these slit-like ejection passages 86L, 86R, respectively, and a slit-like solution inlet passage 90 extending vertically upward from the top of the buffer chamber 84 to the inlet port 33 (FIGS. 1 and 2).

The lower surface of the nozzle 20 extends from both the ejection ports 88L, 88R to the left and right outsides in the widthwise direction (X direction), thereby forming guide surfaces 92L, 92R. The guide surfaces 92L, 92R are formed with one or more groove-like uneven sections 94L, 94R (three in the illustrated exemplary embodiment) which extend in the longitudinal direction of the nozzle (Y direction) in parallel to the slit-like ejection ports 88L, 88R.

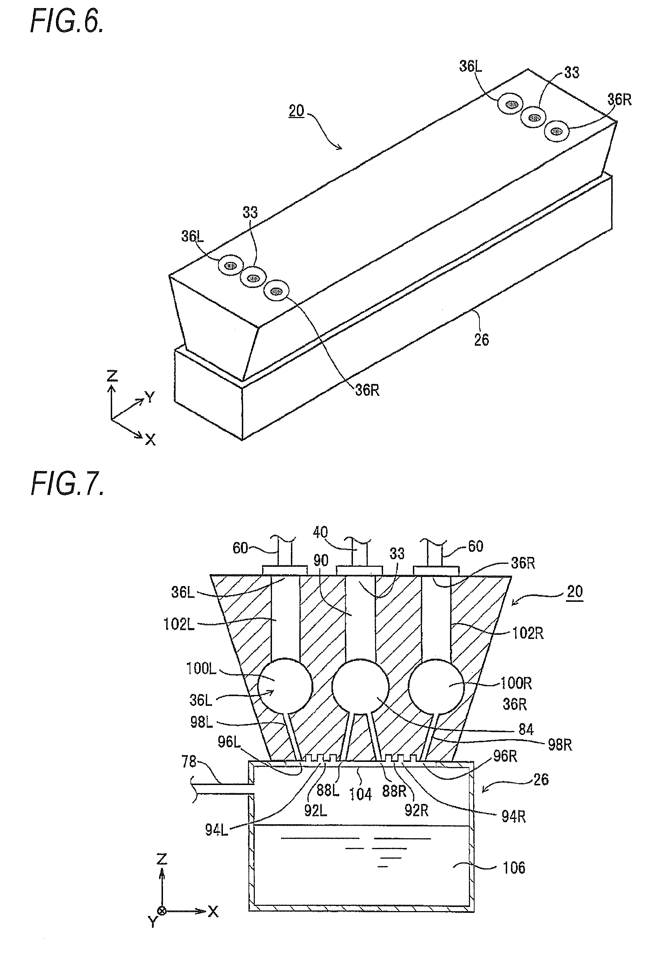

In addition, in the outside of the groove-like uneven sections 94L, 94R, suction ports 96L, 96R of the suction sections 30L, 30R which also extend in the longitudinal direction of the nozzle in parallel to the slit-like ejection ports 88L, 88R are formed on the guide surfaces 92L, 92R, respectively. The pair of left and right suction ports 96L, 96R are connected to the outlet ports 36L, 36R, respectively, through slit-like lower vacuum passages 98L, 98R, tunnel-like buffer chambers (manifolds) 100L, 100R, and slit-like upper vacuum passages 102L, 102R which are formed in the inside of the nozzle 20 (FIG. 7).

Next, the actions of the dye adsorption device of the present exemplary embodiment will be described.

The substrate G is carried into the processing chamber 10 and placed on the chuck plate 14 of the substrate holding unit 12 by a transport robot. Just after this, the nozzle movement mechanism 22 is operated to move the nozzle 20 in the X direction from the standby position P₂ on the nozzle standby unit 26 to the processing position P₁ on the chuck plate 14. In this processing position P₁, the bottom surface of the nozzle 20, in particular, the nozzle ejection ports 88L, 88R and the groove-like uneven sections 94L, 94R are opposed to the substrate G on the chuck plate 14 through a defined gap.

Subsequently, the dye solution supply unit 32, the dye solution recovery unit 34 and the driving unit 18 of the substrate holding unit 12 are operated to initiate the dye adsorption processing.

In the dye solution supply unit 32, the electromagnetic open/close valve 42 is opened and the supply pump 44 is operated so that the dye solution is sent from tank 38 to the inlet port 33 of the nozzle 20 through the dye solution supply line 40 at a predetermined flow rate. In the nozzle 20, the dye solution introduced into the inlet port 33 enters into the buffer chamber 84 through the solution inlet passage 90, passes through the solution ejection passages 86L, 86R, and then is ejected from slit-like ejection ports 88L, 88R onto the substrate G. As the dye solution is ejected onto the substrate G from the slit-like ejection port 88L, 88R, the dye solution compressively contacts with the treated surface (porous semiconductor layer 204) of the substrate G with a predetermined impact force.

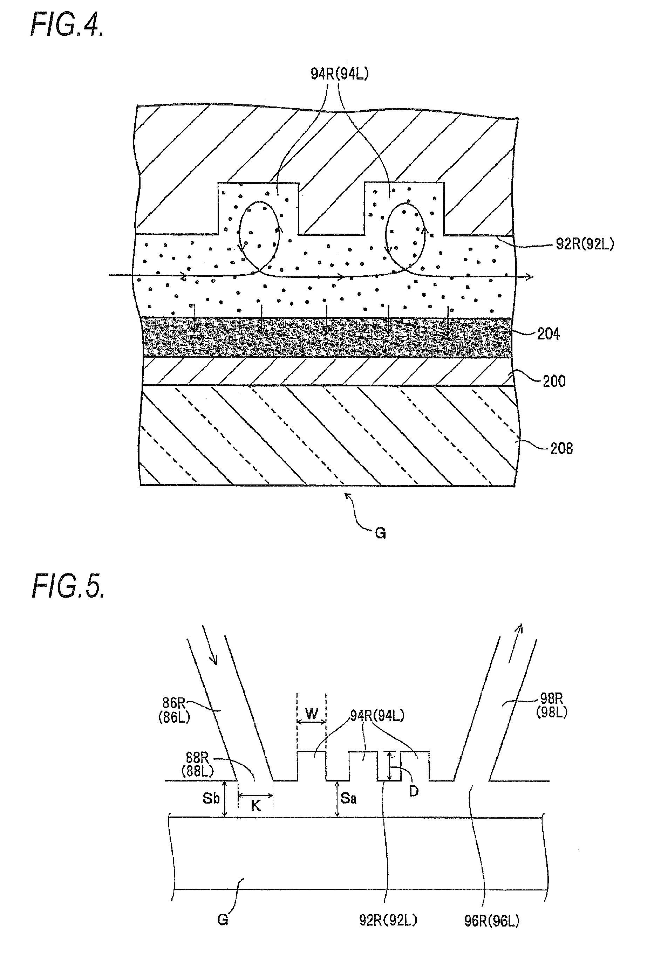

In addition, the dye solution ejected onto the substrate G from both the ejection ports 88L, 88R flows toward the left and right outsides, i.e., toward the suction ports 96L, 96R along the left and right guide surfaces 92L, 92R, as illustrated in FIG. 3B. At this time, as illustrated in FIG. 4, whirlpool or turbulent flow in the vertical direction is generated in the flow of the dye solution by the groove-like uneven sections 94L, 94R of the guide surfaces 92L, 92R and thus, the contact pressure of the dye solution in relation to the treated surface (porous semiconductor layer 204) of the substrate G may be increased.

After passing through the groove-like uneven sections 94L, 94R, the dye solution is sucked into the suction ports 96L, 96R. In the dye solution recovery unit 34, the electromagnetic open/close valve 64 is opened and the suction pump 58 is operated, the dye solution sucked into the suction sections 30L, 30R of the nozzle 20 from the top side of the substrate G is recovered through the outlet ports 36L, 36R of the nozzle 20 and the vacuum line 60.

The driving unit 18 of the substrate holding unit 12 rotates the substrate G integrally with the chuck plate 14 at a predetermined rotation speed in the circumferential direction or azimuthal direction during the processing. With this rotation of the substrate G, the flow of the dye solution may reach every part on the entire treated surface of the substrate G. Also, a point where the movement of the substrate G is in a forward direction in relation to the flow of the dye solution and a point where the movement of the substrate G is in a reverse direction in relation to the flow of the dye solution occur on the treated surface of the substrate G. In order to reduce the variation of the relative velocity between the flow of the dye solution and the movement of the substrate G, it is desirable to rotate the substrate G at a low speed (e.g., about 1 ppm to 10 ppm).

In addition, when the ejection ports 88L, 88R of the nozzle protrude to the outside of the substrate G while the substrate G is being rotated, the dye solution ejected from the ejection ports 88L, 88R is scattered around the substrate G. However, the scattered dye solution is collected to the bottom of the processing chamber 10 and recovered to the dye solution recovery unit 32 from the exhaust/drain port 72.

As described above, in the present exemplary embodiment, a flow of the dye solution is formed in the gap between the guide surfaces 92L, 92R of the nozzle 20 and the substrate G, and the porous semiconductor layer 204 of the treated surface of the substrate G is subject to a dye adsorption processing in this flow of the dye solution. Further, in addition to the flow of the dye solution, impact pressure from the slit-like ejection ports 88L, 88R and the pressure of turbulent flow in the groove-like uneven sections 94L, 94R act in the vertical direction. Thus, aggregation or cohesion of the dye is hardly caused on the surface layer portion of the porous semiconductor layer 204, the dye efficiently penetrates deeply into the porous semiconductor layer 204, and the dye adsorption into the porous semiconductor layer 204 proceeds at high speed. When the method of the present exemplary embodiment is used, the dye adsorption processing time in a process of fabricating a dye sensitization solar cell may be significantly shortened, and finished, for example, within 10 minutes.

In the present exemplary embodiment, it is required to form the groove-like uneven sections 94L, 94R with a proper size in order to generate the turbulent flow of the dye in the groove-like uneven sections 94L, 94R of the nozzle efficiently, stably and securely as described above. According to the repeated experiments performed by the inventor, assuming that the gap size (a set value) between the guide surfaces 92R(92L) and the substrate G is Sₐ as illustrated in FIG. 5, it has been found out that the width W of the groove-like uneven sections 94R(94L) may be selected preferably in the range of 0.3Sₐ to 1.5Sₐ, and the most preferable effect may be obtained in the range of 0.5Sₐ to 1.0Sₐ. In addition, it has been found out that the depth D of the groove-like uneven sections 94R(94L) may also be selected preferably in the range of 0.3Sₐ to 1.5Sₐ, and the most preferably in the range of 0.5Sₐ to 1.0Sₐ.

In addition, since ejecting pressure imparted to the treated surface of the substrate G from both the ejection ports 88L, 88R of the nozzle 20 is also important as described above, the gap size S_{b} between both the ejection ports 88R(88L) and the substrate G may be optimized independently from the gap size of the solution guide surface 92R(92L) size, and the slit width K may be preferably selected in a proper size. However, the slit width K may be typically selected to be Sb ≒ K ≒ Sa.

The dye adsorption processing in the present exemplary embodiment is ended as the dye solution supply unit 32, the dye solution recovery unit 34 and the driving unit 18 of the substrate holding unit 12 are stopped after the predetermined time elapses. Just after this, the nozzle movement mechanism 22 is operated to move the nozzle 20 from the processing position P₁ on the chuck plate 14 to the standby position P₂ on the nozzle standby unit 26. The substrate holding unit 12 releases the adsorptive holding of the substrate G on the chuck plate 14, lifts the substrate G upward from the chuck plate 14 by the lift pin mechanism to hand the substrate G over to the transport robot.

As illustrated in FIGS. 6 and 7, the nozzle standby unit 26 is configured as an elongated solvent storage unit having a top side opening 104 corresponding to the nozzle 20. While the nozzle 20 is standing by on the nozzle standby unit 26, the ejection ports 88L, 88R, the groove-like uneven sections 94L, 94R and the suction ports 96L, 96R on the bottom surface of the nozzle 20 are exposed to the vapor of the solvent within the nozzle standby unit 26. Thus, blockage does not occur.

In addition, while the nozzle 20 is being spaced apart from the nozzle standby unit 26, the open/close valve 80 of the exhaust line 78 (FIG. 1) is opened so that local exhaust within the nozzle standby unit 26 is performed. Thus, vapors of the solvent 106 from the nozzle standby unit 26 do not leak to the surroundings.

### [Exemplary Embodiment 2]

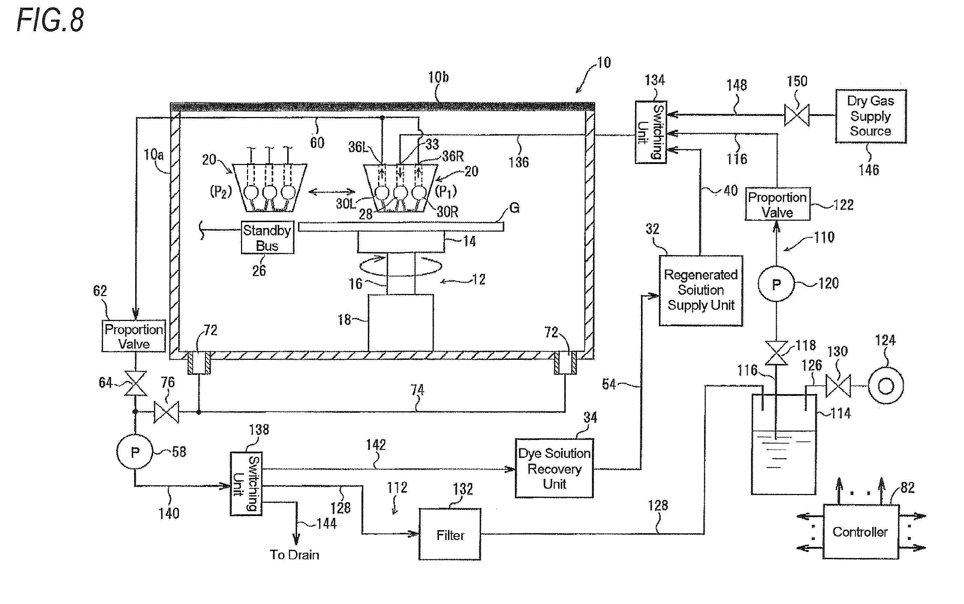

FIG. 8 illustrates the entire configuration of a substrate treatment apparatus according to the second exemplary embodiment of the present invention. In the drawing, the components having the same configuration or function as those of the first exemplary embodiment (FIGS. 1 to 7) will be denoted by the same symbols.

The substrate treatment apparatus includes, as a dye adsorption unit, the dye adsorption device of the first exemplary embodiment as it is, and further includes a rinse unit and a dry unit. In the present exemplary embodiment, the rinse unit includes a substrate holding unit 12, a nozzle 20, a rinse solution supply unit 110, and a rinse solution recovery unit 112. Here, the substrate holding unit 12 and the nozzle 20 are used in the rinse unit and the dry unit as well as in the dye adsorption unit. In addition, the suction pump 58, the vacuum line 60, the electromagnetic proportion valve 62, and the electromagnetic open/close valve 64 are shared between the dye solution recovery unit 34 of the dye adsorption unit and the rinse solution recovery unit of the rinse unit.

The rinse solution supply unit 110 includes: a tank 114 configured to store rinse solution; a rinse solution supply line 116 configured to supply the rinse solution from the tank 114 to the nozzle 20 and formed by, for example, a pipe; an electromagnetic open/close valve 118; a supply pump 120; and an electromagnetic proportion valve 122 in which the electromagnetic open/close valve 118, the supply pump 120, and the electromagnetic proportion valve 122 are provided on the way of the rinse solution supply line 116. The electromagnetic proportion valve 122 is used in order to variably control or adjust the pressure or flow rate of the rinse solution drawn up from the tank 114 and pumped to the nozzle 20 by the supply pump 120.

A new solution supply pipe 126 from the rinse solution supply source 124 and a rinse solution recovery pipe 128 from the rinse solution recovery unit 112 are connected to the tank 114 in order to replenish the tank 114 with the rinse solution. An electromagnetic open/close valve 130 is provided on the way of the new solution supply pipe 126 to be capable of frequently supplying the new rinse solution from the rinse solution supply source 124 to the tank 114 through the new solution supply pipe 126. The rinse solution recovery unit 112 is provided with a filter 132 on the way of the rinse solution recovery pipe 128 to remove dirt or impurity. The rinse solution may be any liquid in which a sensitizing dye is solved and, for example, alcohols, ethers, amides and a hydrocarbon may be properly used.

In the present exemplary embodiment, in order to allow the nozzle 20 to be shared among the dye adsorption unit, the rinse unit and the dry unit, a first switching unit 134 including, for example, a direction control valve is provided, the inlet port 33 of the nozzle 20 is connected to an output port of the first switching unit 134 through a common fluid supply line 136 formed by, for example, a pipe, and the dye solution supply line 40, the rinse solution supply line 116 and a tailing end of a gas supply line 148 from the dry unit to be described later are connected to three input ports of the switching unit 134, respectively.

In addition, in order to allow the suction pump 58, the vacuum line 60, the electromagnetic proportion valve 62, and the electromagnetic open/close valve 64 to be shared between the dye solution recovery unit 34 of the dye adsorption unit and the rinse solution recovery unit 112 of the rinse unit, a second switching unit 138 including, for example, a direction control valve is provided, the outlet side of the suction pump 58 is connected to an input port of the second switching unit 138 through a liquid discharge pipe 140, and a dye solution recovery pipe 142, the rinse solution recovery pipe 128 and the leading end of a drain pipe 144 are connected to three output ports of the switching unit 138, respectively.

The dry unit includes a dry gas supply source 146 including, for example, a warm blast generator or a blow fan, and is configured to be capable of pumping dry gas (e.g., air and nitrogen gas) at a predetermined flow rate to the nozzle 20 through the gas supply line 148, the switching unit 134, and the fluid supply line 136. An open/close valve 150 is provided on the way of the gas supply line 148.

As in the exemplary embodiment 1, the controller 82 includes a microcomputer and an interface as needed, controls each unit in the dye adsorption device (dye adsorption unit, rinse unit and dry unit), and further controls the sequence of the entire apparatus for executing a dye adsorption step, a rinse step, and a dry step.

In the substrate treatment apparatus, the dye adsorption step, the rinse step and the dry step are sequentially performed for the treated substrate G placed on the chuck plate 14 of the substrate holding unit 12 within the processing chamber 10.

The dye adsorption step is executed by the dye adsorption unit under the control of the controller 82. In such a case, the inlet side of the first switching unit 134 is switched to the dye solution supply line 40 and the outlet side of the second switching unit 138 is switched to the dye solution recovery pipe 142. As in the dye adsorption processing in the first exemplary embodiment, the dye solution from the dye solution supply unit 32 is sent to the nozzle 20 at a predetermined flow rate and the dye solution from the slit-like ejection ports 88L, 88R is ejected onto the substrate G which is rotated integrally with the chuck plate 14. As such, the dye solution is compressively contacted with the treated surface (porous semiconductor layer 204) of the substrate G at a predetermined impact force, and further whirlpool or turbulent flow is generated in the vertical direction in the flow of the dye solution in the groove-like uneven sections 94L, 94R of the solution guide surfaces 92L, 92R of the nozzle 20, thereby increasing the contact pressure of the dye solution in relation to the treated surface (porous semiconductor layer 204) of the substrate G. Thus, aggregation or cohesion of the dye is hardly caused on the surface layer portion of the porous semiconductor layer 204, the dye effectively penetrates deeply into the porous semiconductor layer 204, and the dye adsorption into the porous semiconductor layer 204 proceeds at a high speed.

As a predetermined time elapses after starting the dye adsorption step, the dye adsorption unit (especially, the dye solution supply unit 32, the dye solution recovery unit 34 and the driving unit 18 of the substrate holding unit 12) is stopped so that the dye adsorption step is ended. Next, the rinse unit starts the rinse step in a state where the nozzle 20 is fixed to the processing position P₁. At this time, the inlet side of the first switching unit 134 is switched to the rinse solution supply line 116. In addition, the open/close valve 64 is opened, and suction pump 58 and the electromagnetic proportion valve 62 are operated. However, just after starting the rinse step, the outlet side of the second switching unit 138 is left connected to the dye solution recovery pipe 142.

In the rinse step, the rinse solution from the rinse solution supply unit 110 is sent to the nozzle 20 at a predetermined flow rate, and the rinse solution is ejected from slit-like ejection ports 88L, 88R of the nozzle 20 to the top side of the substrate G which is rotated integrally with the chuck plate 14. As such, a flow of the rinse solution is formed in the gap between the guide surfaces 92L, 92R of the nozzle 20 and the substrate G, and the porous semiconductor layer 204 of the treated surface of the substrate is subject to rinse processing in such flow of the rinse solution. With this rinse processing, extra dye or dye solution adhered to or remaining on the surface of the porous semiconductor layer 204 is promptly washes off.

When the extra dye or dye solution adhered to or remaining on the surface of the porous semiconductor layer 204 by the dye adsorption step is left as it is, there is a concern that the dye coheres and precipitates and thus, photovoltaic conversion efficiency may decrease. In the present exemplary embodiment, the extra dye is removed from the surface of the porous semiconductor layer 204 by the rinse processing as described above. Therefore, the cohesion and precipitation of the dye on the surface layer portion of the porous semiconductor layer 204 may be effectively avoided. Thus, the efficiency, reproducibility and stability of photovoltaic conversion in a dye sensitization solar cell may be enhanced.

In the present exemplary embodiment, since the outlet side of the second switching unit 138 is in the state where it is switched to the dye solution recovery pipe 142 just after starting the rinse step or in the initial stage, the used rinse solution (recovered solution) mixed with the dye solution discharged from the outlet ports 36L, 36R of the nozzle 20 is sent to the dye solution recovery unit 34 through the vacuum line 60, the second switching unit 138 and the dye solution recovery pipe 14. The dye solution recovery unit 34 produces a regenerated dye solution from the recovered solution which is mixed with the dye solution, and sends the regenerated dye solution to the tank 38 of the dye solution unit 32 (FIG. 1).

However, the dye solution mixed in the recovered solution is gradually diluted as the rinse step proceeds. Thus, after the middle stage of the rinse step, the outlet side of the second switching unit 138 is switched to the rinse solution recovery pipe 128 and the recovered solution is sent to the rinse solution recovery unit 112. Alternatively, the outlet side of the second switching unit 138 may be switched to the drain pipe 144 in the middle stage of the rinse step and switched to the rinse solution recovery pipe 128 only in the late state of the rinse step.

After the lapse of predetermined processing time from the start of the rinse step, the rinse unit (especially, the rinse solution supply unit 110, the rinse solution recovery unit 112 and the driving unit 18 of the substrate holding unit 12) is stopped to end the rinse step. Next, the dry unit starts the dry step in a state where the nozzle 20 is fixed to the processing position P₁. In such a case, the inlet side of the first switching unit 134 is switched to the gas supply line 148 and the open/close valve 150 is opened. Meanwhile, the open/close valve 64 of a dye solution/rinse solution recovery system is left closed. However, the exhaust of the inside of the processing chamber 10 is continued by operating the suction pump 58 in the state where the open/close valve 76 is opened. The outlet side of the second switching unit 138 is switched to the drain pipe 144.

In the dry step, dry gas is sent from the dry gas supply source 146 to the nozzle 20 at a predetermined flow rate, and the dry gas is injected from slit-like ejection ports 88L, 88R of the nozzle 20 to the treated surface of the substrate G which is rotated integrally with the chuck plate 14. Thus, the rinse solution adhered to the treated surface of the substrate G is blown away by the gas stream from the nozzle 20 and thus, the treated surface of the substrate G is dried.

After a predetermined processing time elapses after starting the dry step, the dry unit (especially, the dry gas supply source 146, the suction pump 58 and the driving unit 18 of the substrate holding unit 12) is stopped and thus, the dry step is ended. Just after this, the nozzle movement mechanism 22 is operated to move the nozzle 20 from the processing position P₁ above the chuck plate 14 to the standby position P₂ above the nozzle standby unit 26. The substrate holding unit 12 releases the adsorptive holding of the substrate G on the chuck plate 14 and lifts the substrate G upward from the chuck plate 14 by the lift pin mechanism to hand the substrate G over to the transport robot.

As described above, the substrate treatment apparatus of the present exemplary embodiment includes the dye adsorption device of the first exemplary embodiment and thus, may significantly reduce the time required for the treatment of adsorbing sensitizing dye into a porous semiconductor layer on a substrate. By being provided with a rinse unit, the substrate treatment apparatus performs rinse processing just after the dye adsorption processing to remove extra dye from surface layer portion of the substrate and effectively prevent or suppress the cohesion and precipitation of the dye, thereby enhancing the efficiency, reproducibility and stability of photovoltaic conversion.

Also, since the nozzle 20 used in the sensitizing dye adsorption processing is used as a post-treatment nozzle, i.e. as a rinse nozzle for rinsing and further as for a dry gas nozzle as it is, the substrate treatment apparatus of the present exemplary embodiment may facilitate the simplification and cost reduction of the entire apparatus as well as the efficiency and time shortening for the entire composite treatments.

In addition, in the exemplary configuration of FIG. 8, the rinse solution supply unit 110 is provided with the dedicated supply pump 120 and the proportion valve 122. However, the supply pump 44 and the proportion valve 46 of the dye solution supply unit 32 may be used as the supply pump 120 and the proportion valve 122, respectively.

Further, although not illustrated, a rinse-only nozzle or a dry-only nozzle may be provided separately from the dye adsorption processing nozzle 20. As for such a rinse-only nozzle or dry-only nozzle, any nozzle well-known or known to public in the related art may be used. However, a separate nozzle with the same construction as the sensitizing dye adsorption processing-only nozzle 20 may be used. Accordingly, when different nozzles are used for different treatments, for example, the substrate holding unit 12 the processing chamber 10 in each treatment may be different from those in any other treatment. In addition, in the dry step, solution removal (dry) from the treated surface of a substrate G may be performed, for example, by rotating the substrate G integrally with the chuck plate 14 without using any nozzle.

### [Other Exemplary Embodiments or Modified Embodiments]

Although several exemplary embodiments have been described above, the present invention is not limited to the above-described exemplary embodiments and other embodiments or various modifications may be made within the sprit and scope of the present invention.

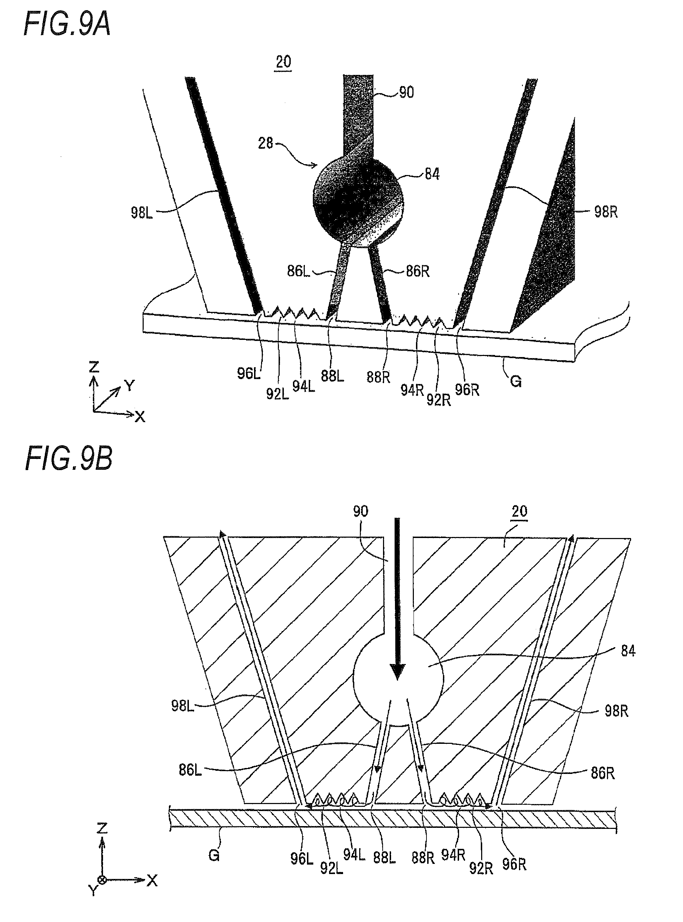

For example, the cross-sectional shape of the groove-like uneven sections 94L, 94R of the nozzle 20 may be formed in a shape other than the quadrilateral shape, for example, in a triangular shape as illustrated in FIGS. 9A and 9B. Also in such a case, in order to cause turbulent flow of the dye solution (or the rinse solution) to be efficiently, stably and securely generated in the groove-like uneven sections 94L, 94R, the ranges of W = 0.3Sₐ to 1.5Sₐ and D = 0.3Sₐ to 1.5Sₐ are preferable, and the ranges of W = 0.5Sₐ to 1.0Sₐ and D = 0.5Sₐ to 1.0Sₐ are most preferable, in which W is the width of the inlets of the groove-like uneven sections 94L, 94R and D is the depth of the groove-like uneven sections 94L, 94R.

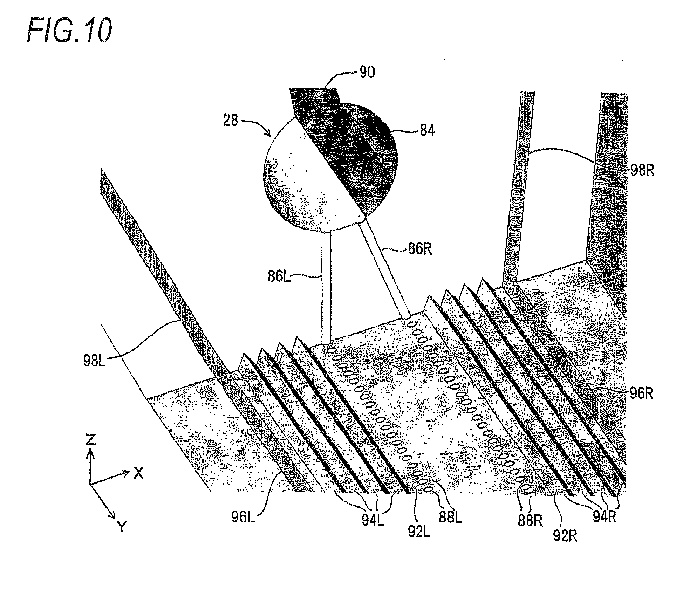

As illustrated in FIG. 10, the ejection passages 86L, 86R and the ejection ports 88L, 88R of the nozzle 20 may also be formed by a plurality of fine holes (tunnels) arranged at a predetermined pitch in the longitudinal direction. Such porous ejection ports have an advantage in that they may further increase ejecting pressure (impact force) against the substrate G.

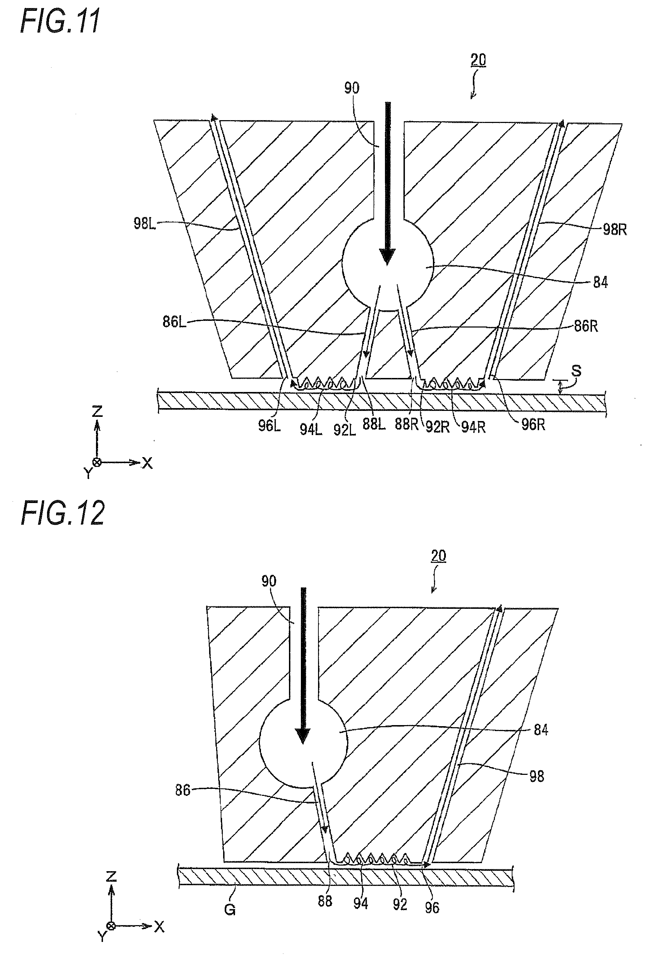

The groove-like uneven sections 94L, 94R of the nozzle 20 are not limited to the construction in which concave portions are deeply formed in relation to the guide surfaces 92L, 92R and may be configured such that convex portions protrude to the gap sides in relation to the guide surfaces 92L, 92R as illustrated in FIG. 11.

Also, as illustrated in FIG. 12, an ejection port 84, a guide surface 92, a groove-like uneven section 94 and a suction port 96 of a single line may be provided in the nozzle 20. In such a case, the substrate movement at each position on the substrate G may be always maintained in the forward direction or reverse direction in relation to the flow of the dye solution on the substrate G. Accordingly, when the substrate movement direction (rotation direction) in the reverse direction is selected, the relative flow velocity of the dye solution (or the rinse solution) may be increased at each position on the substrate G.

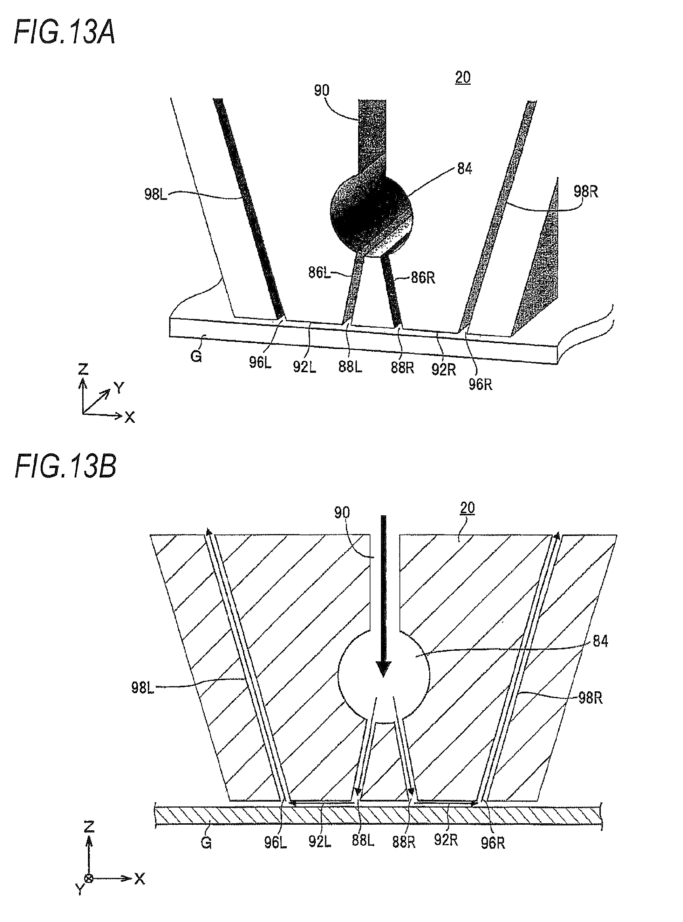

As another exemplary embodiment, as illustrated in FIGS. 13A and 13B, the groove-like uneven sections 94L, 94R may be omitted from the guide surfaces 92L, 92R of the nozzle 20. As described above, the groove-like uneven sections 94L, 94R of the nozzle 20 greatly contribute to the speedup of the dye solution treatment by generating whirlpool or turbulent flow in the flow of dye solution (or rinse solution) on the substrate G. Accordingly, omission of the groove-like uneven sections 94L, 94R may decrease the efficiency of the dye adsorption processing (or rinse processing) and increase processing time by the extent that may be obtained with the groove-like uneven sections 94L, 94R. However, in comparison with the conventional dipping method, the efficiency of the dye adsorption processing is exceptionally high and processing time is remarkably shortened due to the flow and ejecting pressure (impact force) of the dye solution.

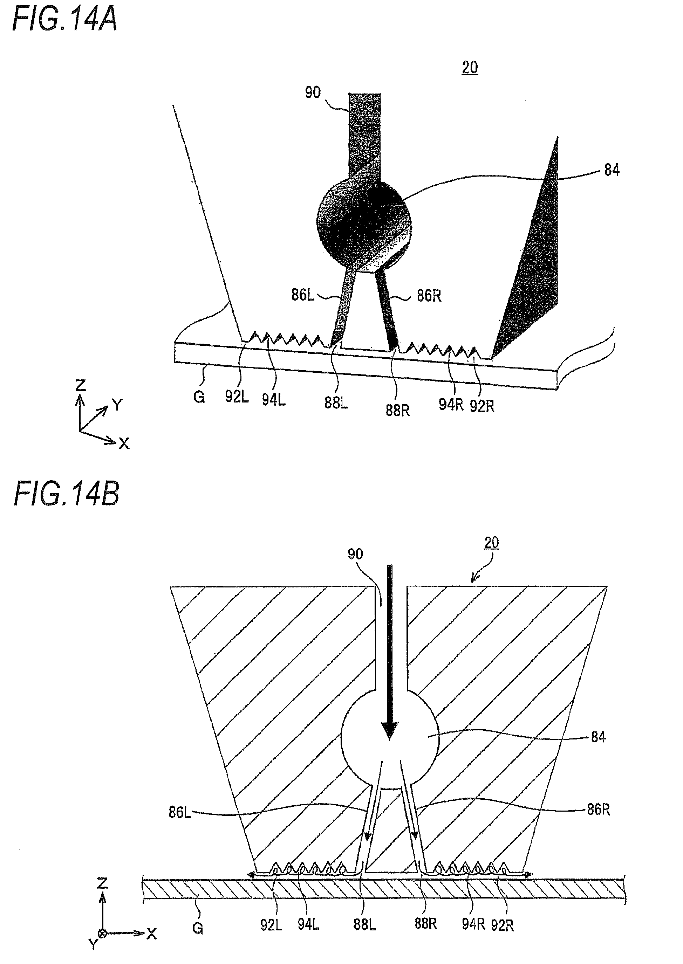

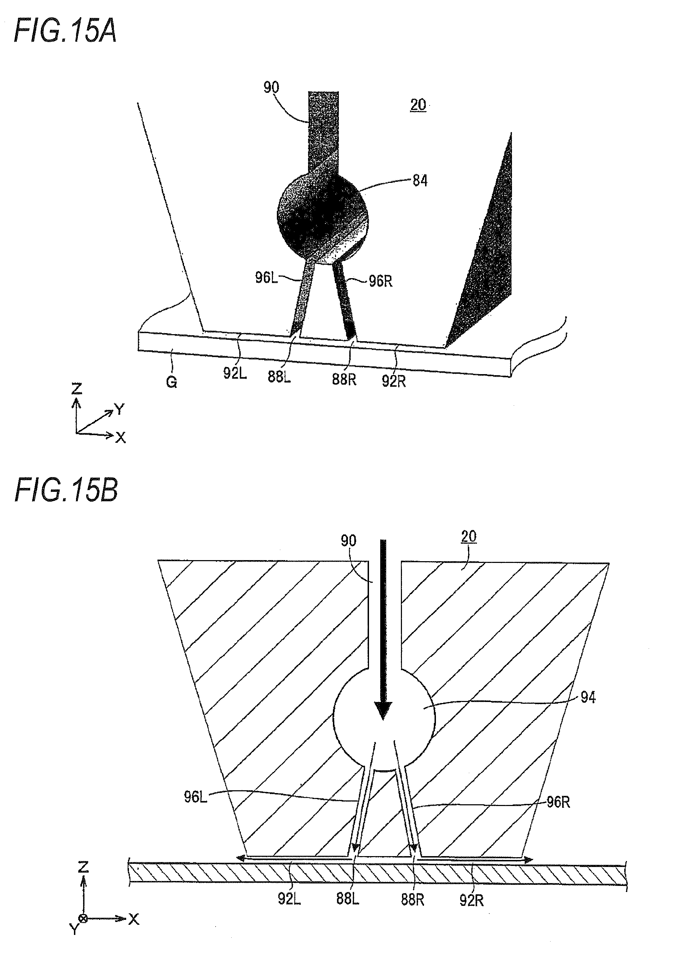

In still another exemplary embodiment, as illustrated in FIGS. 14A and 14B or FIGS. 15A and 15B, the suction sections 30L, 30R may be omitted from the nozzle 20. In such a case, omission of the suction sections 30L, 30R may slacken the flow of dye solution (or rinse solution) on the substrate G, decrease the efficiency of dye adsorption processing (or rinse processing), and increase a processing time by the extent that may be obtained with the suction sections 30L, 30R. However, in comparison with the conventional dipping method, the efficiency of dye adsorption processing is high and processing time is shortened.

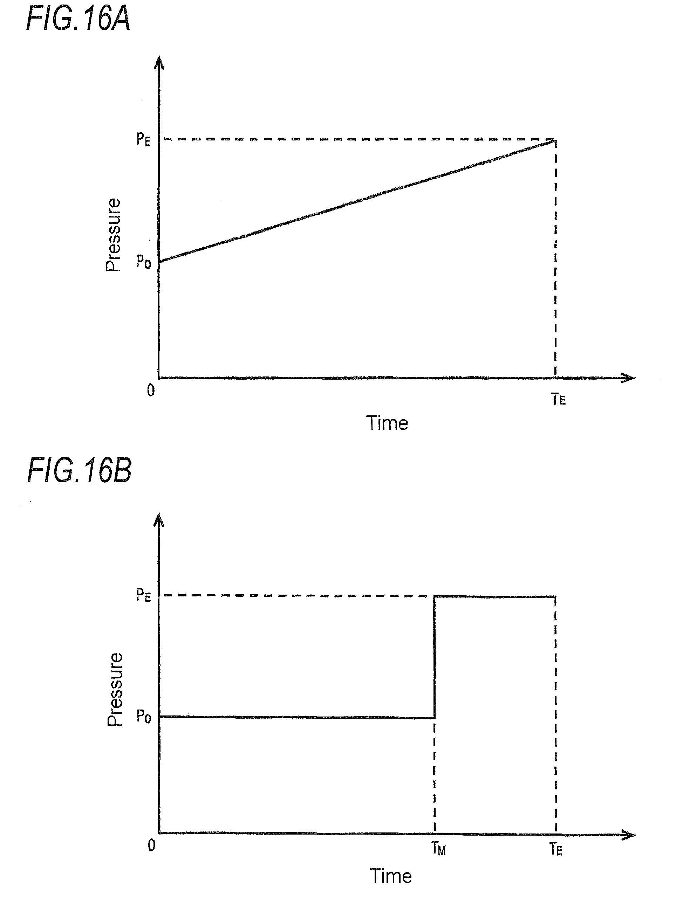

Also, the loss caused by the omission of the level suction section 30L, 30R may be replenished by variably controlling the ejecting pressure or ejecting flow rate of the nozzle 20. That is, when the suction sections 30L, 30R are not provided, the flow of the dye solution on the substrate G is slackened and thus, the dye adsorption efficiency may be decreased as the processing time elapses. Thus, as illustrated in FIG. 16A, it may be proper to employ a method of increasing the ejecting pressure (or ejecting flow rate) of the nozzle 20 step by step as time passes through the electromagnetic proportion valves 46, 62 at a time interval (preferably, the later half) or over the entire time interval (T=0 to T=T_{E}) in the processing time.

In addition, in one of the above-described exemplary embodiments, the substrate G is rotated in the azimuthal direction during the processing on the substrate holding unit 12. In another exemplary embodiment, it may also be possible repeatedly reciprocate the nozzle 20 at constant cycle in the horizontal direction (X direction) orthogonal to the longitudinal direction of the nozzle 20 (Y direction) by operating the nozzle movement mechanism 22. In such a case, when the whole length of the nozzle 20 (ejection port 88) is set to correspond to the length of the substrate in the longitudinal direction of the nozzle 20 (Y direction), the opposite ends of the nozzle 20 (ejection port 88) may not protrude to the outside of the substrate G (that is, the dye solution may be completely suppressed from scattering to the surroundings).

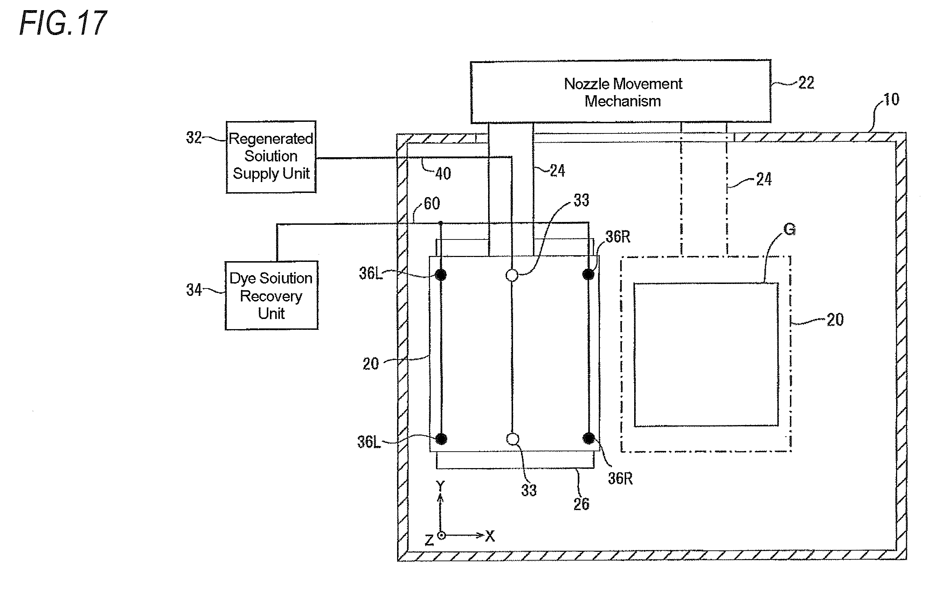

Alternatively, as illustrated in FIG. 17, the nozzle 20 may be configured to have a size much larger than that of the substrate G not only in the longitudinal direction of the nozzle 20 (Y direction) but also in the widthwise direction of the substrate G (X direction) so that the nozzle 20 may completely cover the substrate G. In such a case, dye adsorption processing may be performed in a state where the nozzle 20 and the substrate G are both stopped.

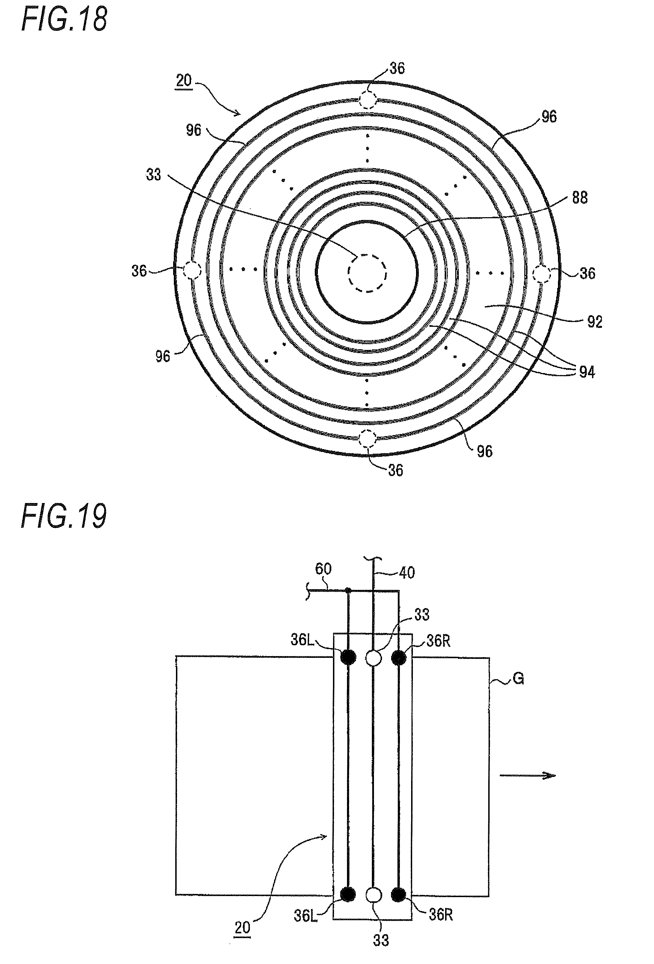

Also, in another exemplary embodiment, as illustrated in FIG. 18, the nozzle 20 may be configured in a disc shape. In such a case, the nozzle 20 includes a circular ejection port 88, a circular guide surface 92, circular groove-like uneven sections 94, and a circular suction port 96 which are concentric to each other.

In addition, although not illustrated, the uneven sections 94(94L, 94R) may be formed in a type other than the groove type, for example, in a dimple type.

Further, in another exemplary embodiment in which a relative movement is performed between the nozzle 20 and substrate G, as illustrate in FIG. 19, it may be possible to provide a configuration that stops the nozzle 20 and rectilinearly moves or reciprocates the substrate G in the horizontal direction (X direction) orthogonal to the longitudinal direction of the nozzle (20) (Y direction). In such a case, as a means for holing and horizontally moving the substrate G, for example, a carrying type or floating type stage or a conveyer may be used.

Also, although not illustrated, the suction sections 30(30L, 30R) may be configured to be independent from the nozzle 20. Accordingly, the suction ports 96(96L, 96R) of a suction sections 30(30L, 30R) of a separate member may be arranged, for example, both sides (or one side) of the nozzle 20 to be spaced apart from the nozzle 20.

The present invention may be properly applied to a step of adsorbing sensitizing dye into a porous semiconductor layer of a dye sensitization solar cell as described above. However, the present invention may also be applied to a treatment of adsorbing any dye into any thin film formed on a surface of a substrate.

### Description of Symbols

10: processing chamber
12: substrate holding unit
22: nozzle movement mechanism
26: standby bus
28: ejection section
30L, 30R: suction section
32: solution supply unit
34: solution recovery unit
40: dye solution supply line
46, 62: electromagnetic proportion valve
60: vacuum line
86L, 86R: ejection passage
88L, 88R: ejection port
92L, 92R: solution guide surface
94L, 94R: groove-like uneven section
96L, 96R: suction port
110: rinse solution supply unit
112: rinse solution recovery unit
134, 138: switching unit
146: dry gas supply source

## Claims

1. A die adsorption apparatus of adsorbing a dye into a porous semiconductor layer formed on a treated surface of a substrate, the apparatus comprising:
a holding unit configured to hold the substrate such that the treated surface of the substrate faces upward;
a nozzle having an ejection port and disposed above the holding unit so that the ejection port faces downward; and
a dye solution supply unit configured to pump a dye solution formed by solving the dye in a predetermined solvent to the nozzle,
wherein the dye solution is ejected from the ejection port of the nozzle to the treated surface of the substrate held on the holding unit through a first gap so that a flow of the dye solution is formed on the treated surface of the substrate and the dye contained in the dye solution is adsorbed into the semiconductor layer.

2. The apparatus of claim 1, further comprising:
a movement mechanism configured to cause a relative movement to be performed between the substrate on the holding unit and the nozzle in parallel to the substrate,
wherein the ejection port of the nozzle is formed in a slit shape, and the flow of the dye solution is formed in a direction intersecting the extending direction of the slit.

3. The apparatus of claim 1, further comprising:
a movement mechanism configured to cause a relative movement to be performed between the substrate on the holding unit and the nozzle in parallel to the substrate,
wherein the ejection port has a plurality of ejection holes arranged in a predetermined direction at a predetermined pitch, and the flow of the dye solution is formed in a direction intersecting the arrangement direction of the ejection holes.

4. The apparatus of claim 1, wherein a guide surface opposed to the treated surface of the substrate through a second gap is formed around or next to the ejection port of the nozzle, and the flow of the dye solution is formed along the guide surface.

5. The apparatus of claim 4, further comprising:
a suction section positioned at a trailing end of the flow of the dye solution on the substrate and configured to suck in the dye solution.

6. A dye adsorption method of adsorbing dye into a porous semiconductor layer formed on a treated surface of a substrate, the method comprising:
disposing the substrate at a predetermined position such that the treated surface of the substrate faces upward;
positioning the nozzle to be opposed to the substrate; and
pumping dye solution formed by solving the dye in a predetermined solvent to the nozzle and ejecting the dye solution from the ejection port of the nozzle to the treated surface of the substrate held on the holding unit through a first gap so that a flow of the dye solution is formed on the treated surface of the substrate and the dye contained in the dye solution is adsorbed into the semiconductor layer.

7. The method of claim 6, further comprising
causing a relative movement to be performed between the substrate and the nozzle in parallel to the substrate during the processing,
wherein the flow of dye solution is formed in a surface parallel to the substrate in a direction intersecting the extending direction or distributed direction of the ejection port.

8. The method of claim 6, wherein the flow of the dye solution is formed along a guide surface of the nozzle which is opposed to the treated surface of the substrate through a second gap around or next to the ejection port of the nozzle.

9. The method of claim 8, wherein the dye solution forms turbulent flow by an unevenness section formed on the guide surface.

10. The method of claim 8, wherein the dye solution is sucked in at a trailing end of the flow of the dye solution, thereby being recovered.

11. The method of claim 6, wherein the ejecting pressure or ejecting flow rate of the nozzle is varied during the processing.

12. The method of claim 11, wherein the ejecting pressure or ejecting flow rate of the nozzle is increased linearly as time passes over an interval or the entire interval in processing time.

13. The method of claim 11, wherein the ejecting pressure or ejecting flow rate of the nozzle is increased step by step during the processing.

14. A substrate treatment apparatus comprising:
a holding unit configured to hold a substrate formed with a porous semiconductor treated surface such that the treated surface faces upward;
a dye adsorption unit configured to adsorb dye to the semiconductor layer of the substrate held on the holding unit;
a rinse unit configured to wash out extra dye from a surface of the semiconductor layer of the substrate,
wherein the dye adsorption unit includes:
a first nozzle having an ejection port and disposed above the holding unit such that the ejection port faces downward, and
a dye solution supply unit configured to pump dye solution in which the dye is solved in a predetermined solvent to the first nozzle, and
wherein the dye solution is ejected from the ejection port of the nozzle to the treated surface of the substrate held on the holding unit through a first gap so that a flow of the dye solution is formed on the treated surface of the substrate and the dye contained in the dye solution is adsorbed into the semiconductor layer.

15. The apparatus of claim 14, further comprising:
a movement mechanism configured to cause a relative movement to be performed between the substrate on the holding unit and the first nozzle in parallel to the substrate,
wherein the ejection port of the first nozzle is formed in a slit shape, and the flow of the dye solution is formed in a direction intersecting the extending direction of the slit.

16. The apparatus of claim 14, further comprising:
a movement mechanism configured to cause a relative movement to be performed between the substrate on the holding unit and the first nozzle in parallel to the substrate,
wherein the ejection port has a plurality of ejection holes arranged in a predetermined direction at a predetermined pitch, and the flow of the dye solution is formed in a direction intersecting the arrangement direction of the ejection holes.

17. The apparatus of claim 14, wherein a guide surface opposed to the treated surface of the substrate through a second gap is formed around or next to the ejection port of the nozzle, and the flow of the dye solution is formed along the guide surface.

18. The apparatus of claim 14, further comprising:
a suction section positioned at a trailing end of the flow of the dye solution on the substrate and configured to suck in the dye solution.

19. The apparatus of claim 14, wherein the ejecting pressure or ejecting flow rate of the nozzle is variable during the processing.

20. The apparatus of claim 19, wherein the ejecting pressure or ejecting flow rate of the nozzle is increased linearly as time passes over an interval or the entire interval of processing time.

21. The apparatus of claim 19, wherein the ejecting pressure or ejecting flow rate of the nozzle is increased step by step during the processing.
